# EUROPEAN PATENT APPLICATION

(11) **EP 4 604 173 A2**
(43) Date of publication of application: **20.08.2025**
(21) Application number: 24189049.0
(22) Date of filing: 17.07.2024
(51) Int. Cl.: H01L 21/763, H01L 21/762

(54) **DEVICE WITH IMPROVED LATCH-UP IMMUNITY**

(30) Priority: 13.02.2024 US 202418440229
(71) Applicant: GLOBALFOUNDRIES Singapore Pte. Ltd., Singapore 738406 (SG)
(72) Inventor: ZHANG, Guowei, 738406 Singapore (SG); AMETHYSTNA, Surya Kris, 738406 Singapore (SG); HERLAMBANG, Aloysius Priartanto, 738406 Singapore (SG)
(74) Representative: Lambacher, Michael

(57) **Abstract**

The present disclosure relates to semiconductor structures and, more particularly, to a device with improved latch-up immunity and methods of manufacture. The structure includes: a semiconductor substate including a layer of a first conductivity type; a first semiconductor material over the layer of the first conductivity type, the first semiconductor layer including the first conductivity type and a layer of a second conductivity type; a second semiconductor material of the second conductivity type over the layer of the second conductivity type; and a deep trench isolation structure electrically connecting to the layer of the first conductivity type, the deep trench isolation layer extending through the first semiconductor material and the second semiconductor material.

## Description

### BACKGROUND

The present disclosure relates to semiconductor structures and, more particularly, to a device with improved latch-up immunity and methods of manufacture.

Latch-up is a condition of a low-impedance path between a power supply (e.g., power pin) and ground by triggering of a parasitic device. For example, this condition may be caused by a trigger (current injection or overvoltage) in a parasitic device, e.g., NPN. In this condition, excessive current flow is possible, and a potentially destructive situation exists. For example, in conventional devices, latch-up weakness presents itself when a high voltage PMOS drain to high voltage n-well are forward biased. Also, once activated, the low-impedance path remains even after the trigger is no longer present.

### SUMMARY

In an aspect of the disclosure, a structure comprises: a semiconductor substate comprising a layer of a first conductivity type; a first semiconductor material over the layer of the first conductivity type, the first semiconductor layer comprising the first conductivity type and a layer of a second conductivity type; a second semiconductor material of the second conductivity type over the layer of the second conductivity type; and a deep trench isolation structure electrically connecting to the layer of the first conductivity type, the deep trench isolation layer extending through the first semiconductor material and the second semiconductor material. Additional features of the structure are set forth in dependent claims 2 to 7.

In an aspect of the disclosure, a structure comprises: a first semiconductor region comprising a first layer with a first conductivity type of a first dopant concentration and a second layer with the first conductivity type with a second dopant concentration; a second semiconductor region comprising a first layer with the first conductivity type and a second layer with a second conductivity type; a third semiconductor region comprising the second conductivity type; a gate structure over the third semiconductor region; and a deep trench isolation structure extending to the first layer with the first conductivity type of the first semiconductor region. Additional features of the structure are set forth in dependent claims 9 to 14.

In an aspect of the disclosure, a method comprises: forming a semiconductor substate comprising a layer of a first conductivity type; forming a first semiconductor material over the layer of the first conductivity type, the first semiconductor layer comprising the first conductivity type and a layer of a second conductivity type; forming a second semiconductor material of the second conductivity type over the layer of the second conductivity type; and forming a deep trench isolation structure electrically connecting to the layer of the first conductivity type, the deep trench isolation layer extending through the first semiconductor material and the second semiconductor material.

### BRIEF DESCRIPTION OF THE DRAWINGS

The present disclosure is described in the detailed description which follows, in reference to the noted plurality of drawings by way of non-limiting examples of exemplary embodiments of the present disclosure.
FIG. 1 shows a structure and respective fabrication processes in accordance with aspects of the present disclosure.
FIGS. 2A-2C show respective fabrication processes of the structure of FIG. 1 in accordance with aspects of the present disclosure.

### DETAILED DESCRIPTION

The present disclosure relates to semiconductor structures and, more particularly, to a device with improved latch-up immunity and methods of manufacture. More specifically, the present device comprises a double diffusion metal oxide semiconductor transistor with improved latch-up immunity. In embodiments, the device comprises a buried P+ semiconductor layer connecting to a deep trench isolation structure, and a P-epitaxial semiconductor layer between the buried P+ semiconductor layer and a buried N+ epitaxial semiconductor layer. Advantageously, the device exhibits improved latch-up immunity and high breakdown voltage.

The structure of the present disclosure can be manufactured in a number of ways using a number of different tools. In general, though, the methodologies and tools are used to form structures with dimensions in the micrometer and nanometer scale. The methodologies, i.e., technologies, employed to manufacture the structure of the present disclosure have been adopted from integrated circuit (IC) technology. For example, the structures are built on wafers and are realized in films of material patterned by photolithographic processes on the top of a wafer. In particular, the fabrication of the structure uses three basic building blocks: (i) deposition of thin films of material on a substrate, (ii) applying a patterned mask on top of the films by photolithographic imaging, and (iii) etching the films selectively to the mask. In addition, precleaning processes may be used to clean etched surfaces of any contaminants, as is known in the art. Moreover, when necessary, rapid thermal anneal processes may be used to drive-in dopants or material layers as is known in the art.

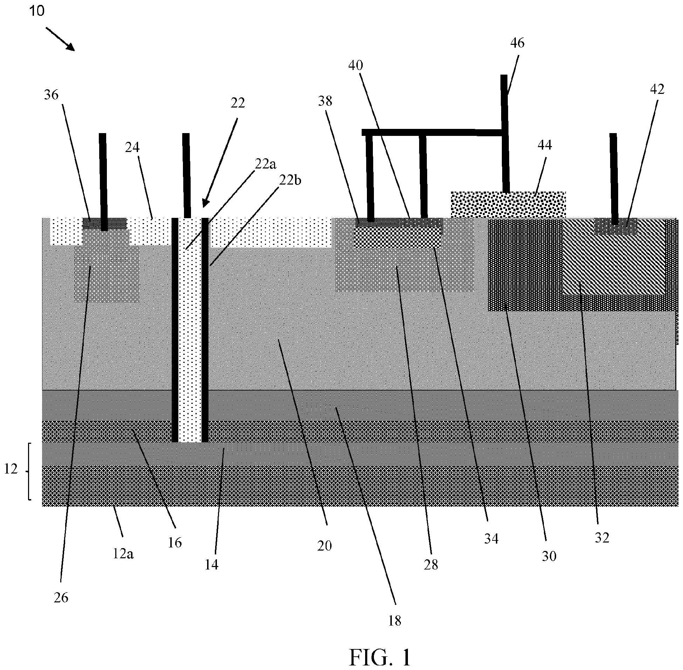

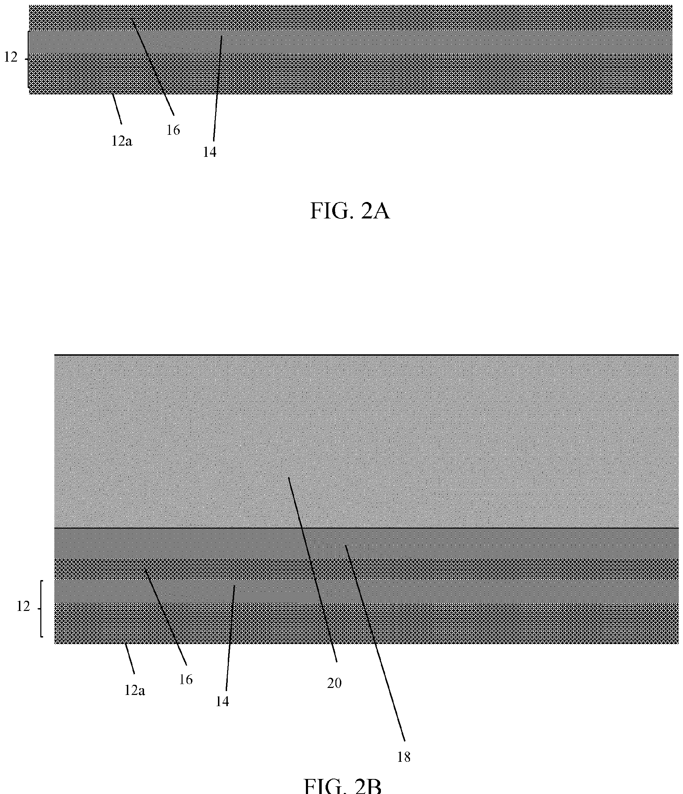

FIG. 1 shows a structure and respective fabrication processes in accordance with aspects of the present disclosure. The structure 10 may be a double diffusion metal oxide semiconductor transistor with improved latch-up immunity. The structure 10 includes a semiconductor substrate 12 with a buried P+ semiconductor layer 14. In embodiments, the P+ semiconductor layer 14 may be provided by an ion implantation process as described with respect to FIG. 2A.

The semiconductor substrate 12 may comprise a p-type semiconductor substrate 12a as is known in the art. The semiconductor substrate 12 may be composed of any suitable material including, but not limited to, Si, SiGe, SiGeC, SiC, GaAs, InAs, InP, and other III/V or II/VI compound semiconductors. In preferred embodiments, the semiconductor substrate 12 may comprise any suitable single crystallographic orientation (e.g., a <100>, <110>, <111>, or <001> crystallographic orientation). The buried P+ semiconductor layer 14 may have a higher dopant concentration and a lower Rs (Ω-cm) than the p-type semiconductor substrate 12a.

Still referring to FIG. 1, a P- semiconductor material 16 may be provided over the buried P+ semiconductor layer 14. In embodiments, the P- semiconductor material 16 may be epitaxial grown semiconductor material with an in-situ p-type dopant, e.g., boron. In embodiments, the P- semiconductor material 16 may be composed of the same semiconductor material as the semiconductor substrate 12. An N+ layer 18 may be provided in the P- semiconductor material 16. In embodiments, the N+ layer 18 may be provided by an ion implantation process as described with respect to FIG. 2B.

An N- semiconductor material 20 may be provided over the N+ layer 18. In embodiments, the N- semiconductor material 20 may be epitaxial grown semiconductor material with an in-situ n-type dopant, e.g., arsenic. In embodiments, the N-semiconductor material 20 may be composed of the same semiconductor material as the semiconductor substrate 12. The P- semiconductor material 16 between the P+ semiconductor layer 14 and the N+ layer 18 will ensure that there is a high breakdown voltage between the P- semiconductor material 16 and the N- semiconductor material 20.

FIG. 1 further shows a deep trench isolation structure 22. The deep trench isolation structure 22 physically and electrically connects to the buried P+ semiconductor layer 14. Accordingly, the deep trench isolation structure 22 extends through the layers 16, 18, 20 to contact the buried P+ semiconductor layer 14. The combination of the buried P+ semiconductor layer 14 and the deep trench isolation structure 22 will act as an isolation structure which significantly reduces the parasitic NPN gain (e.g., N-well 26/p-type semiconductor substrate 12a/N- semiconductor material 20) and, thus, improves its latch-up immunity. In this way, it is now possible to inject a higher current into the device for improved performance, i.e., increased reliability. In other words, improvement in latch-up weakness has now been achieved when HVPMOS drain to HVNWELL are forward biased.

The deep trench isolation structure 22 comprises sidewalls composed of conductive material 22a and filled with insulator material 22b. The conductive material 22a may be polysilicon material. The insulator material 22 may be, for example, SiO₂. The deep trench isolation structure 22 is surrounded by a shallow trench isolation structure 24 within the N- semiconductor material 20. It should also be understood by those of skill in the art that the deep trench isolation structure 22 may surround the entire device region, e.g., gate structure 44 with its source and drain regions.

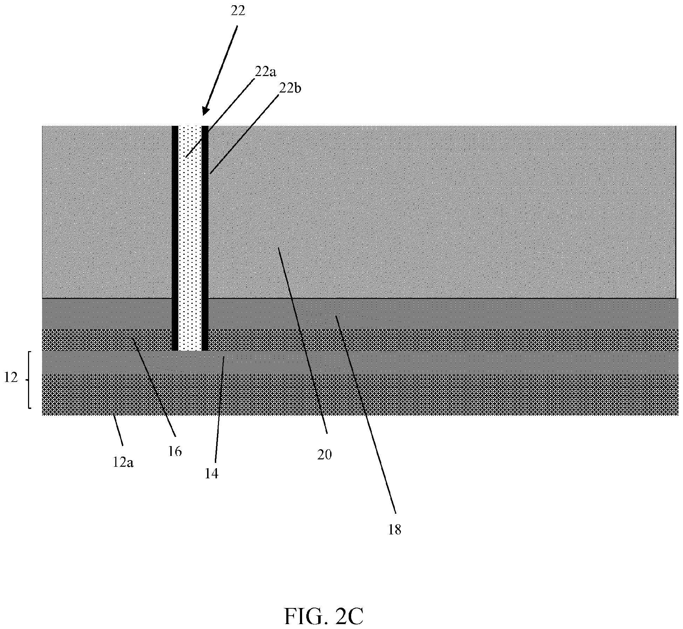

The deep trench isolation structure 22 and the shallow trench isolation structure 24 may be formed by conventional lithography, etching and deposition methods known to those of skill in the art. For example, a resist formed over the N- semiconductor material 20 is exposed to energy (light) and developed utilizing a conventional resist developer to form a pattern (opening). An etching process with a selective chemistry, e.g., reactive ion etching (RIE), will be used to transfer the pattern from the patterned photoresist layer to the N- semiconductor material 20 to form one or more trenches through the openings of the resist. The resist may be removed by a conventional oxygen ashing process or other known stripants. For the deep trench isolation structure 22, conductive material 22a (e.g., polysilicon) and insulator material 22b can be deposited within the trench as described with respect to FIG. 2C. For the shallow trench isolation structure 24, the deposition of conductive material will not be required; instead, insulator material 22b, e.g., SiO₂, will fill the trench. Any residual insulator material and/or conductive material on the surface of the N- semiconductor material 20 may be removed by conventional chemical mechanical polishing (CMP) processes.

FIG. 1 further shows wells 26, 28, 30, 32 formed in the N- semiconductor material 20. In embodiments, the wells 26, 28 may be n-wells; whereas the wells 30, 32 may be p-wells of different dopant concentrations. For example, the well 30 may be a lower dopant concentration than the well 32. Moreover, the well 30 may be a high voltage PMOS drain (HVPMOS). The n-well 28 may also include a well body 34, e.g., n-well body. The n-well body 34 may have a higher dopant concentration than the n-well 28. In embodiments, the well 30 may be a HVNWELL.

The wells 26, 28, 30, 32, 34 may be formed by a conventional ion implantation process. For example, the wells 26, 28, 30, 32, 34 may be formed by introducing a concentration of different dopants and, as appropriate, of opposite conductivity type in the N- semiconductor material 20. In embodiments, respective patterned implantation masks may be used to define selected areas exposed for the implantations. As is known, the implantation mask used to select the exposed area for forming wells 26, 28 may be stripped after implantation, and before the implantation mask used to form wells 30, 32, 34 (or vice versa). The implantation masks may include a layer of a light-sensitive material, such as an organic photoresist, applied by a spin coating process, pre-baked, exposed to light projected through a photomask, baked after exposure, and developed with a chemical developer. Each of the implantation masks has a thickness and stopping power sufficient to block masked areas against receiving a dose of the implanted ions. The p-wells 30, 32 are doped with p-type dopants, e.g., Boron (B), and the n-wells 26, 28, 34 are doped with n-type dopants, e.g., Arsenic (As), Phosphorus (P) and Antimony (Sb), among other suitable examples. An annealing process may be performed to drive in the dopants into the N- semiconductor material 20 as is known in the art.

FIG. 1 further shows N+ and P+ regions within the wells 26, 28, 30, 32, 34. The N+ regions 36, 38 are formed in the wells 26, 28, 34 and the P+ regions 40, 42 are formed in the wells 28, 32. In embodiments, the N+ region 38 may be a base region, the P+ region 40 may be a source region of a gate structure 44 and the P+ region 42 may be a drain region of the gate structure 44. As shown, the gate structure 44 extends over the wells 28, 30. The N+ and P+ regions 36, 38, 40, 42 may be formed by conventional ion implantation processes as already described herein, noting that the N+ and P+ regions 36, 38, 40, 42 will have a higher dopant concentration than the respective wells 26, 28, 30, 32, 34.

Although not critical to the understanding of the present disclosure, the gate structure 44 can be fabricated using conventional CMOS processes. For example, the gate structure 44 can be fabricated using standard CMOS or replacement gate processes. In the standard CMOS processing, a gate dielectric and polysilicon are formed, e.g., deposited, onto the N- semiconductor material 20, followed a patterning process, with the polysilicon material forming a gate body. The gate dielectric may be a high-k or a low-k dielectric material as is known in the art. An insulator material such as nitride or oxide or combinations thereof can be deposited on the patterned materials, followed by an anisotropic etching process to form sidewalls.

Wiring structures 46 may connect to the N+ and P+ regions 36, 38, 40, 42, the gate structure 44 and the deep trench isolation structure 22. The wiring structures 46 may be back end of the line structures, e.g., via interconnects and wiring layers as is known in the art. The wiring structures 46 may be composed of any conventional conductive material, e.g., aluminum, TiN, TaN, tungsten, etc., formed by conventional lithography, etching and deposition methods as described herein. The wiring structure 46 connected to the P+ region 42 may be used for injecting a current into the high-voltage drain region (e.g., p-well 32).

Prior to forming the wiring structures 46, the N+ and P+ regions 36, 38, 40, 42, gate structure 44 and deep trench isolation structure 22 (e.g., polysilicon material 22a) may be subjected to a silicide process. As should be understood by those of skill in the art, the silicide process begins with deposition of a thin transition metal layer, e.g., nickel, cobalt or titanium, over fully formed and patterned semiconductor devices (e.g., N+ and P+ regions 36, 38, 40, 42, gate structure 44 and deep trench isolation structure 22). After deposition of the material, the structure is heated allowing the transition metal to react with exposed silicon (or other semiconductor material as described herein) in the active regions of the semiconductor device (e.g., source, drain, and gate contact regions) forming a low-resistance transition metal silicide. Following the reaction, any remaining transition metal is removed by chemical etching, leaving silicide contacts in the active regions of the device. It should be understood by those of skill in the art that silicide contacts will not be required on gate structure composed of a metal material.

FIGS. 2A-2C show respective fabrication processes of the structure 10 of FIG. 1 in accordance with aspects of the present disclosure. FIG. 2A shows the p-type substrate 12a with the P+ semiconductor layer 14 and P- semiconductor material 16. The P+ semiconductor layer 14 has a higher doping concentration than either the p-type substrate 12a and P- semiconductor material 16.

In embodiments, the P+ semiconductor layer 14 is formed by an ion implantation process as already described herein. In embodiments, the doping concentration is higher in the P+ semiconductor layer 14 than the p-type substate 12a. As a non-limiting example, the doping concentration of the P+ semiconductor layer 14 may be 1E19 and the doping concentration of the p-type substrate 12a may be 1.5E15; although other doping concentrations are also contemplated herein. In this way, Rs will be lower for the P+ semiconductor layer 14, e.g., 0.001 Ω-cm, compared to 10 Ω-cm.

The P- semiconductor material 16 may be epitaxially grown on the P+ semiconductor layer 14. As with each of the semiconductor materials, the P-semiconductor material 16 may be composed of any suitable material including, but not limited to, Si, SiGe, SiGeC, SiC, GaAs, InAs, InP, and other III/V or II/VI compound semiconductors. Examples of various epitaxial growth processes that can be employed in the present disclosure include, e.g., rapid thermal chemical vapor deposition (RTCVD), low-energy plasma deposition (LEPD), ultra-high vacuum chemical vapor deposition (UHVCVD), atmospheric pressure chemical vapor deposition (APCVD) and molecular beam epitaxy (MBE). The epitaxial growth may be performed at a temperature of from 300° C. to 800° C. The epitaxial growth can be performed utilizing any well-known precursor gas or gas mixture. Carrier gases like hydrogen, nitrogen, helium and argon can be used. A dopant (p-type) may be added to the precursor gas or gas mixture for an in-situ doping process.

In FIG. 2B, an N+ layer 18 may be provided in the P- semiconductor material 16. In embodiments, the N+ layer 18 is provided by an ion implantation process. An N-semiconductor material 20 may be provided over the N+ layer 18 by an epitaxial process with in-situ doping process. The N+ layer 18 in the P- semiconductor material 16 will have a higher doping concentration than the N- semiconductor material 20. The N-semiconductor material 20 and N+ layer may be doped with Arsenic (As), Phosphorus (P) and Antimony (Sb), among other suitable examples.

In FIG. 2C, the deep trench isolation structure 22 is formed through layers 20, 18, 16 and connecting to the buried P+ semiconductor layer 14. In this way, the deep trench isolation structure 22 physically and electrically connects to the buried P+ semiconductor layer 14. The deep trench isolation structure 22 may be formed by conventional lithography, etching and deposition methods known to those of skill in the art as described above.

For the deep trench isolation structure 22, conductive material 22a (e.g., polysilicon) can be deposited within the trench by any conventional deposition processes, e.g., chemical vapor deposition (CVD) processes to form the sidewalls 22a. An anisotropic etching process may be used to remove the conductive material from the bottom of the trench. The conductive material 22a will make physical and electrical contact with the buried P+ semiconductor layer 14. Insulator material 22b may be deposited within the remaining portion of the trench to form the deep trench isolation structure 22. The deep trench isolation structure 22 may be formed before or after the shallow trench isolation structure 24 as shown in FIG. 1. The remaining processes for fabricating wells and contacts are described with respect to FIG. 1.

The structure can be utilized in system on chip (SoC) technology. The SoC is an integrated circuit (also known as a "chip") that integrates all components of an electronic system on a single chip or substrate. As the components are integrated on a single substrate, SoCs consume much less power and take up much less area than multichip designs with equivalent functionality. Because of this, SoCs are becoming the dominant force in the mobile computing (such as in Smartphones) and edge computing markets. SoC is also used in embedded systems and the Internet of Things.

The method(s) as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various embodiments of the present disclosure have been presented for purposes of illustration, but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A structure comprising:
a semiconductor substate comprising a layer of a first conductivity type;
a first semiconductor material over the layer of the first conductivity type, the first semiconductor material comprising the first conductivity type and a layer of a second conductivity type;
a second semiconductor material of the second conductivity type over the layer of the second conductivity type; and
a deep trench isolation structure electrically connecting to the layer of the first conductivity type, the deep trench isolation layer extending through the first semiconductor material and the second semiconductor material.

2. The structure of claim 1, wherein the first conductivity type comprises a p-type dopant and the second conductivity type comprises an n-type dopant.

3. The structure of claim 1 or claim 2, wherein the first conductivity type of the first semiconductor material contacts the layer of the first conductivity type of the semiconductor substrate, and/or wherein the second conductivity type of the second semiconductor material contacts the layer of the second conductivity type of the first semiconductor material.

4. The structure of one of claims 1 to 3, wherein the layer of the first conductivity type of the semiconductor substrate comprises a buried P+ dopant layer.

5. The structure of one of claims 1 to 4, wherein the layer of the first conductivity type comprises a higher dopant concentration than the first conductivity type of the first semiconductor material, and/or wherein the layer of the second conductivity type comprises a higher dopant concentration than the second semiconductor material of the second conductivity type.

6. The structure of one of claims 1 to 5, wherein the deep trench isolation structure comprises a conductive liner on sidewalls and insulator material between the conductive liner, and, optionally, wherein the conductive liner comprises polysilicon material.

7. The structure of one of claims 1 to 6, further comprising a gate structure comprising a gate body, drain region and source region, wherein the deep trench isolation structure and the layer of the first conductivity type isolate the gate structure.

8. A structure comprising:
a first semiconductor region comprising a first layer with a first conductivity type of a first dopant concentration and a second layer with the first conductivity type with a second dopant concentration;
a second semiconductor region comprising a first layer with the first conductivity type and a second layer with a second conductivity type;
a third semiconductor region comprising the second conductivity type;
a gate structure over the third semiconductor region; and
a deep trench isolation structure extending to the first layer with the first conductivity type of the first semiconductor region.

9. The structure of claim 8, wherein the first dopant concentration is higher than the second dopant concentration of the first semiconductor region and the first conductivity type of the second semiconductor region, and/or wherein the second conductivity type of the second layer of the second semiconductor region comprises a higher dopant concentration than the second conductivity type of the third semiconductor region.

10. The structure of claim 8 or claim 9, wherein the first layer with the first conductivity type of the first semiconductor region is buried between the second layer with the first conductivity type of the first semiconductor region and the first layer with the first conductivity type of the second semiconductor region.

11. The structure of one of claims 8 to 10, wherein the first conductivity type comprises a p-type dopant and the second conductivity type comprises an n-type dopant.

12. The structure of one of claims 8 to 11, wherein the deep trench isolation structure comprises an insulator material and a sidewall lined with a conductive material, and, optionally, wherein the conductive material comprises polysilicon.

13. The structure of one of claims 8 to 12, wherein the deep trench isolation structure contacts the first layer with the first conductivity type of the first semiconductor region.

14. The structure of one of claims 8 to 13, further comprising a drain region and a source region adjacent to the gate structure, the drain region comprises a high-voltage drain region connecting to an injection source.

15. A method comprising:
forming a semiconductor substate comprising a layer of a first conductivity type;
forming a first semiconductor material over the layer of the first conductivity type, the first semiconductor layer comprising the first conductivity type and a layer of a second conductivity type;
forming a second semiconductor material of the second conductivity type over the layer of the second conductivity type; and
forming a deep trench isolation structure electrically connecting to the layer of the first conductivity type, the deep trench isolation layer extending through the first semiconductor material and the second semiconductor material.
